# EUROPEAN PATENT APPLICATION

(11) **EP 0 628 806 A2**
(43) Date of publication of application: **14.12.1994**
(21) Application number: 94106670.6
(22) Date of filing: 28.04.1994
(51) Int. Cl.: G01N 21/88

(54) **Image measurement system and method**

(30) Priority: 30.04.1993 US 56161
(71) Applicant: International Business Machines Corporation, Armonk, N.Y. 10504 (US)
(72) Inventor: Budd, Russell Alan, Chappaqua, NY 10514 (US); Chang, Isabella Diana Min, Chappaqua, NY 10514 (US); Dove, Derek Brian, Mt.Kisco, NY 10549 (US); Staples, John Leroy, Pleasantville, NY 10570 (US)
(74) Representative: Schäfer, Wolfgang, Dipl.-Ing.

(57) **Abstract**

An apparatus and method for determining the characteristics of a photolithographic mask (44) including a multi-wavelength light source (20), frequency selection means (22) for providing light of a selected frequency from the light source, coherence adjusting means (24-39) for adjusting coherence of the selected light, positioning means (42) for adjustable positioning of an object (44) with respect to the apparatus (12), and an imaging means (46, 48) for producing an enlarged optically equivalent image of the mask (44), the imaging means (46, 48) including an adjustment means (50) for adjusting numerical aperture, and image capture means (15) for capturing the image produced by the imaging means (46, 48). The light may be in the ultraviolet range and the image capture means (15) may be ultraviolet CCD camera.

## Description

### Background of the Invention

### Technical Field

This invention relates to a method and system for quantitatively evaluating photolithographic masks. More particularly it relates to a system which can produce data concerning phase shift and chrome masks and their defects and can provide optical images useful for evaluating the mask and defects by quantitatively analyzing the data produced.

### Background Art

The production of microelectronic circuits with features of smaller size requires the ability to create images of correspondingly smaller size. As a practical matter, optical imaging systems using light in the visual range have a resolution limit of approximately 1 micron.

One way in which to produce higher resolution images is to decrease the wavelength of the energy used to expose the photoresist material that is then developed to produce the image. Energy in the ultraviolet region of the electromagnetic spectrum will not pass through ordinary optical elements. Thus it is required that lenses and masks be fabricated from materials such as quartz which readily transmit ultraviolet light.

An extremely promising new technology for producing high resolution images requires the use of so called "phase shift masks". Typically, these masks image "light" or electromagnetic energy in the ultraviolet portion of the spectrum.

By changing the "optical thickness" of the mask in predetermined patterns, advantageous optical interference effects as produced which may enhance resolution, depth of focus and contrast. Thus, the desired features are projected on to the photoresist. However, if there are errors in the phase shift produced when light travels through the mask, the image produced on the photoresist will be inaccurate or distorted and the advantages noted above will not be realized.

One prior art method for evaluating the effectiveness of phase shift masks is a functional test. The mask is placed in an optical stepper and used to expose photoresist. The images produced are evaluated to determine whether the mask is suitable for producing the features intended. The difficulty with this functional test is that it is costly, time consuming and does not provide detailed information on the nature of the errors in the mask which contribute to the unacceptable image being formed.

Another technique for evaluating phase shift masks is to physically measure the depth of etch or of the various layers on the mask. While this may ascertain the accuracy of the actual physical dimensions, there is no assurance that the mask will perform optically in a manner which provides the desired phase shift. For example, the preferred phase shift is generally 180 degrees. While the depth of quartz removed to provide such a phase shift may be measured as equivalent to 180 degrees at the wavelength of interest, there is no assurance that the particular area of the phase shift mask actually produces the desired phase shift.

It is thus evident that there is a very real need for some method or apparatus for determining the actual performance of a phase shift mask without the need to use the mask to expose actual photoresist patterns. Further, there is a need for a method or apparatus which develops data that is more representative of the actual performance of the mask than can be obtained by direct dimensional measurement.

### Summary of the Invention

It is a principal object of the present invention to provide an apparatus and method for the evaluation of photolithographic masks.

It is another object of the invention to provide a method and apparatus for acquiring data concerning photolithographic masks, analyzing this data, and providing images representative of the data which permit evaluation of the performance of the mask.

In accordance with the invention an apparatus for the determination of the characteristics of a photolithographic mask comprises a multi-wavelength light source; frequency selection means for providing light of a selected frequency from the light source; coherence adjusting means for adjusting coherence of the selected light; positioning means for adjustable positioning an object with respect to the system; and imaging means for producing an enlarged optically equivalent image of the mask, the imaging means including an adjustment means for adjusting numerical aperture thereof; and image capture means for capturing the image produced by the imaging means.

In accordance with the invention, the system further comprises an angle adjusting means for adjusting the angle of the mask illuminating light with respect to the optical axis of the imaging means. The frequency selection means permits adjustment of the selected frequency so that different discreet frequencies can be selected. The system further comprises display means for displaying the image captured by the imaging means. The system may also comprise analyzing means for analyzing the image captured by the image capturing means. Preferably the analyzing means comprises a programmed digital computer. The system may further comprise control means for controlling size of an illuminated region of the object as well as pupil filling adjustment means for adjusting a pupil filling ratio. In addition, the system comprises focus adjustment means and the image capture means captures data at different focal depths as focus is changed by the focus adjusting means.

In accordance with the invention a method for obtaining images representative of the performance of a photolithographic mask comprises the steps of providing electromagnetic energy of a selected frequency; adjusting the coherence of the energy provided; positioning the photolithographic mask so that said electromagnetic energy illuminates a selected portion of the mask; producing an enlarged optically equivalent stepper image of the mask; and capturing the image produced.

In accordance with the method of the invention, data from the image may be analyzed and a display representative of selected regions of the mask may be produced. In order to further evaluate the mask, successive images at points above and below focus for the imaging means may be captured and the data analyzed to determine the properties of the mask.

### Brief Description of the Drawings

- Fig. 1: is a block diagram of a system in accordance with the invention.
- Fig. 2: is a schematic diagram of the optical system of Fig.1.
- Fig. 3A: is a diagram which illustrates the pupil filling ratio of the optical system of Fig. 2.
- Fig.3B-3E: illustrate various aperture arrangements for the optical system of Fig. 2.
- Fig. 4: is a high level flow chart of the computer program used for operating the system of Fig. 1.
- Fig. 5: is a flow chart of the data analysis block of Fig. 4.
- Fig. 6: is a flow chart of various applications for the system of Fig. 1.

### DETAILED DESCRIPTION OF THE PREFERRED EMBODIMENTS

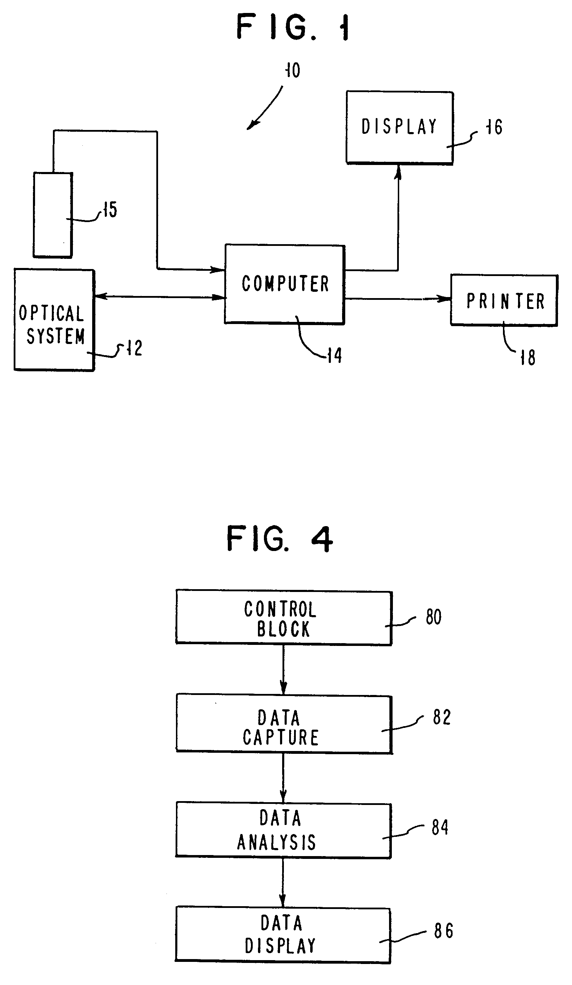

Referring to Fig. 1, a system 10 in accordance with the invention includes an optical system 12 having many of the characteristics of an optical microscope column. A computer 14 is interfaced to the optical system for control of several of the components thereof. Computer 14 is also interfaced to a camera 15 based on charge coupled devices (i.e. a CCD camera) for acquiring images from optical system 12. This CCD camera 15 may be of the type manufactured by Photometrics of Tucson, Arizona. It may be, for example, a 512 x 512 pixel device, wherein each pixel has dimensions of 19 X 19 &mu.m. Camera 15 preferably has spectral sensitivity in the 240-900 nanometer range.

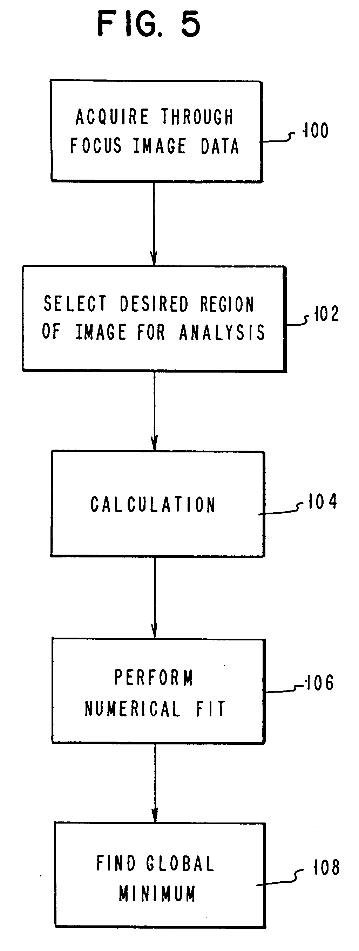

Computer 14, operating with software more fully described below with respect to Fig. 4 and Fig. 5 acquires data from the CCD camera 15 and analyzes and presents this data on a display 16. A permanent copy of what is displayed thereon can be provided by a printer 18 also interfaced to computer 14.

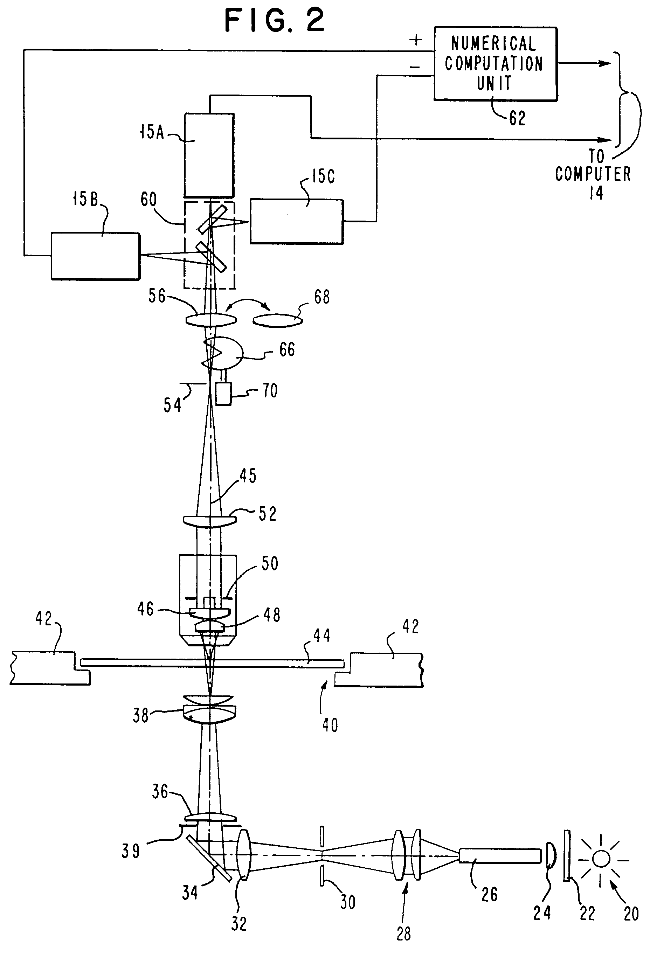

Referring to Fig. 2 optical system 12, includes a lamp 20 which provides ultraviolet radiation including wavelengths in the deep ultraviolet range. It may be a 100 watt Hg-Xe arc lamp mounted in a suitable lamp housing. Light from lamp 20 is filtered by a filter 22 which selects a particular wavelength or spectroscopic "line" for use by optical system 12. Such filters are well known in the art, and are selected to pass wavelengths of approximately 250 and 365 nanometers to match those generally used in optical stepper systems. Alternatively a laser or monochromatic light source of the desired wavelength or wavelengths may be used.

Energy of the wavelength selected by filter 22 is collected by a condenser lens 24 to form a beam of relatively small diameter. However, this beam is generally of larger dimension than that desirable for illumination of a relatively small area of the phase shift mask for purposes of conducting measurements using system 10. The light from condenser 24 is passed through a telescope system 26 which reduces the beam diameter to a fraction of its size at the input of telescope 26. Typically, the beam is reduced to approximately one fifth to one tenth that of the beam received from condenser lens 24.

The light emerging from telescope 26 travels through a series of relay lenses including a lens system 28, an additional lens 32, a field lens 36 and a condenser lens system 38. Between lens 32 and field lens 36 light changes direction due to reflection by a mirror 34. Between lens 28 and lens 32 is an aperture 30 which, as more fully explained below has the principal function of permitting adjustment of the value of sigma, or the pupil filling ratio for the objective lens also described below.

An illumination size control aperture 39 is located in the optical path between mirror 34 and field lens 36. Typically it is sized so that a desired area of a mask is illuminated.

Light emerging from condenser lens system 38 is supplied to an opening 40 in a stage 42, on which the phase shift mask 44 to be evaluated, is placed. The position of stage 42 with respect to the optical axis 45 of optical system 12 is controlled by mechanical means in three dimensions, in a manner well known in the art. A portion of the computer program which operates computer 14 is designed to interface with the mechanical control system so that a record can be made of the portion of mask 44 that is being evaluated for appropriate storage with the image data provided by the system. Further, the computer program permits the operator to send commands to the mechanical system for positioning of the stage 42 at a selected position. In other words, X and Y movement in the plane of mask 44 selects the portion of the mask to be examined.

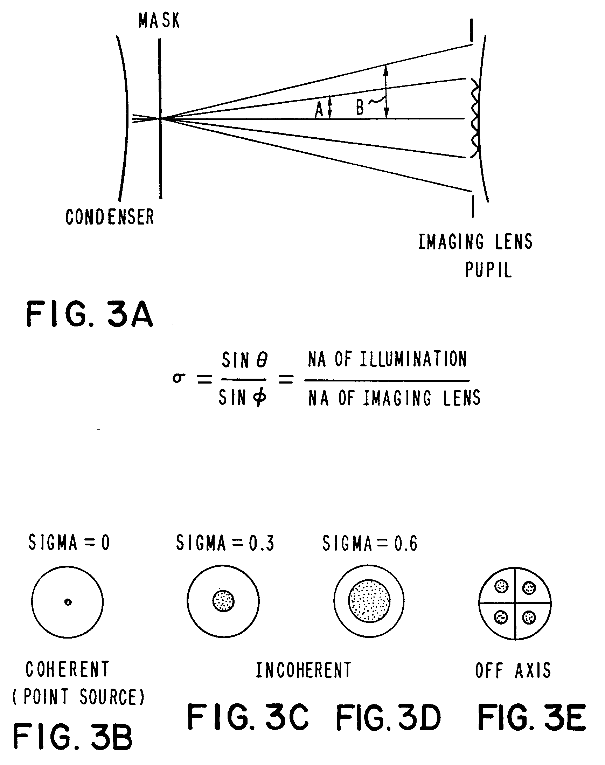

Light passing through mask 44 reaches an objective lens 46 having an objective lens system 48 and an adjustable aperture 50 for numerical aperture (NA) control in the range of 0.03 to 0.35. To produce a stepper equivalent image for a stepper of for example N.A. = 0.4 and magnification 5X an aperture of 0.4/5 ie. 0.08 is selected. Or in another example for a stepper of NA = 0.5 and magnification 4X, an aperture of 0.5/4 ie., 0.125 is selected. The relationship between this numerical aperture and the aperture 30 which sets the pupil filling ratio is discussed below with respect to Fig. 3A.

Light emerging from objective lens 46 is then focused by a standard microscope tube lens 52 into an image plane 54. At this point, the image has been multiplied in size by only the power of the objective lens 46 and is generally not large enough for viewing. An additional magnification lens 56 again increases the size of the image. As an example, objective lens 46 may be a 10 power lens while magnification lens 56 may be a 15 power lens to provide a total magnification factor of 150. Generally factors of the order of 100 are satisfactory. Designs which are telecentric are preferred; that is the image preferably should not change size with change of focus.

It will be understood that provisions also will be made for adjusting the distance of objective lens 46 from mask 44 for focusing, as is well known in the art. This can be accomplished manually, or with appropriate drive mechanisms, under the control of computer 14.

The magnified image from lens 56 is the image that is supplied to a CCD camera. However, in Fig. 2 there is shown a first camera 15A as well as two additional CCD cameras 15B and 15C. An optical beam splitter arrangement 60 is used to divide the light travelling along optical axis 45 into three different beams for the cameras 15A, 15B and 15C. Camera 15A is positioned so that the image that it receives is in focus. Camera 15B is positioned so that it receives an image which is slightly out of focus in a first direction. Camera 15C is positioned so that it receives an image that is slightly out of focus in the opposite direction with respect to the image received by camera 15B.

The data outputs of cameras 15B and 15C may be sent to a numerical computation unit 62. The data can thus be compared on a real time basis and then the result of the comparison sent to computer 14. Alternatively, both outputs can be supplied to computer 14 for subsequent analysis.

The outputs of cameras 15B and 15C may be subtracted, divided or otherwise manipulated by unit 62 or computer 14 to enhance the detectability of phase defects.

While the system illustrated in Figure 2 has advantages in that different images can be simultaneously acquired, and real time comparisons can be made, it will be understood that the system is more expensive than the use of a single camera as illustrated in Fig. 1. However, a system having only one camera can be used to obtain the same data provided there is motion of the mask through focus and the data is recorded for each position. Image subtraction can then be carried out by operations on the acquired data. This method is more time consuming.

As yet another alternative, the focal condition may be varied by use of an interposed plate 66. This plate may have a region which changes the length of the optical pathway and a region which does not. The plate may be alternately introduced and taken out of the optical path. This may be motorized, with for example, the plate 66 being spun by a motor 70 so that the defect region may be viewed as a flickering region on a viewing screen receiving data from a single camera.

Additional information on the phase error may be obtained by varying the wavelength of the illumination provided by the lamp 20. Preferably, the wavelength is changed until the phase error disappears. If this is the case, the phase error for the desired wavelength may be calculated precisely. For example a phase shift of 200 degrees at the "I" line (365 nanometers) would not be visible (i.e. would be 180 degrees) at 320 nanometers.

An additional feature of the optical system of Fig. 2 is the ability to switch from a lens 56 which permits imaging of the mask 44 to a lens 68 which permits imaging of aperture 30. This permits direct observation of the pupil filling factor, sigma, discussed below.

In the discussion below with respect to sigma and numerical aperture, reference will be made to Fig. 3A to Fig. 3E. The aperture 30 of Fig. 2 is located at a position which is conjugate in the optical system to the aperture 50 of the objective lens 46. The adjustment of the size and nature of aperture 30 determines what is known in stepper technology as the coherence of the illumination.

Referring to Fig. 3A the relationship between condenser lens 38, mask 44 and the pupil of objective lens 46 is illustrated. The pupil filling ratio, sigma, is defined as the sine of the angle A over the sine of the angle B. The sine of angle A is approximately equal to the numerical aperture of illumination while the sine of angle B is approximately equal the numerical aperture of the imaging lens. Thus, sigma is equal to the numerical aperture of illumination divided by the numerical aperture of the imaging lens.

It is useful to change the size of the aperture 30 as illustrated in Figures 3B, 3C and 3D so as to change the coherence of the illumination. In effect, this permits modeling of different stepper illumination systems and their interaction with the particular phase shift mask 44 being tested. In Fig. 3B, sigma is effectively equal to zero because a point source (a rather small opening) is used. In Fig. 3C, a larger opening is used and sigma may be, for example, equal to 0.3. In Fig. 3D, a rather large aperture is used and a sigma may be, for example, equal to 0.6. Fig. 3C and Fig. 3D represent incoherent light sources.

Other types of apertures of a more complex configuration may be used. For example four small apertures which are off axis as illustrated in Fig. 3E., may be used. Other off axis illumination configurations, as described by various stepper manufacturers may be simulated.

In addition, other illumination patterns may be utilized. For example, annular plate having grooves or a phase plate may be utilized at aperture 30 for examining certain selected types of masks.

Referring to Fig. 4 a high level flow chart of the computer program used by computer 14, in accordance with the invention, is illustrated. The program includes a control block 80 which interfaces with the mechanical controls of optical systems 12 to permit the user of the system to setup the system for making measurements. Appropriate modules are provided for interface and control of a stage positioning apparatus and for focusing the image via motion of stage 42 with respect to objective lens 46 (Fig. 2).

A data capture module 82 receives data concerning position from the X-Y stage controls as well as image data from CCD camera 15. Data received is analyzed in a data analysis module 84 as more fully described below with respect to Fig. 5. This module analyses the data to provide output concerning the transmission intensity and phase of light in the image produced as a function of position on the phase shift mask.

Module 86 is a data display block. As a result of the data analysis performed in step 84, appropriate images are created for use by display 16 or for generating hardcopy outputs with printer 18 (Fig. 1).

The image data can be analyzed in several ways once it is collected. Two of the most important parameters of a phase shift mask are its phase and transmission values. The determination of these phase and transmission values by the comparison of the image data with theoretical simulations will now be described with respect to Fig. 5.

At step 100 image is acquired through focus as described above. The system is set to emulate a specific stepper equivalent condition. The image of the feature of interest is acquired at several chosen focal planes. The range and number of these focal planes is dependent on the desired accuracy and on the specific stepper condition being emulated.

At step 102 a region of the desired feature, such as a line or contact is selected for analysis. This can be the whole feature, a particular area of the feature or a line profile through a particular section of the feature.

At step 104 theoretical calculations using an appropriate range of mask phase and transmission values are performed for the feature of interest at the specific stepper equivalent condition emulated by the system. These calculations result in a phase versus transmission matrix of through focus aerial images, to be used for comparison with measured data. A library of features can be developed and stored in a memory associated with computer 14 (Fig 1).

At step 106 an appropriate numerical fit of measured data to theoretical aerial images (as defined in Block 104 and stored in the memory of computer 14) is performed for the entire through focus phase versus transmission image matrix. This numerical fit results in a matrix, each of whose values represents the degree to which the measured data matches the simulated aerial image for a particular phase and transmission. For example, if the region of interest of the feature is a line profile, a non-linear least squares fit of measured profile data to theoretical profiles may be used to determine the degree of correlation.

At step 108 the matrix of correlation values is fitted to determine the global minimum. This global minimum represents particular phase and transmission values corresponding to the imaging behavior of the phase shift mask.

In general, in using the system and method in accordance with the invention, the starting point is a mask which has certain features and phase shift as a function of positioning in the xy plane. The system simulates a particular stepper environment, including the use of the mask with a stepper lens, and produces a plot of intensity of the resulting image as a function x and y positions in the plane, and z position (in a direction perpendicular to the plane of the image by under focus and over focus as described above). There are two primary areas of applicability of the data. First, the data can be used to determine the resulting resist dimensions. In other words the resist patterns that will result after the exposure can be determined. Further this pattern can be determined as a function of the extent of departure from the ideal focal plane. Thus, critical dimensions of features that will be exposed and the criticality of the focus can be determined. This will often determine whether a mask is useable. Further, data can be determined concerning defect printability. For example, if a defect exists but is not be printed when the mask is used, then the mask may be acceptable. Various analysis methods including threshold models and resist simulations can be used.

Alternatively, the system can be used to generate information concerning the structure of the mask. For example, data on the phase and transmission of the mask is determined as set forth above with respect to Fig. 5. Further, defects may be characterized. Finally, various analysis methods can be used to convert the raw data into useful information. For example, this can be done by comparison to the data generated by a known mask having acceptable properties or by comparison to simulation data to determine the quality of the mask.

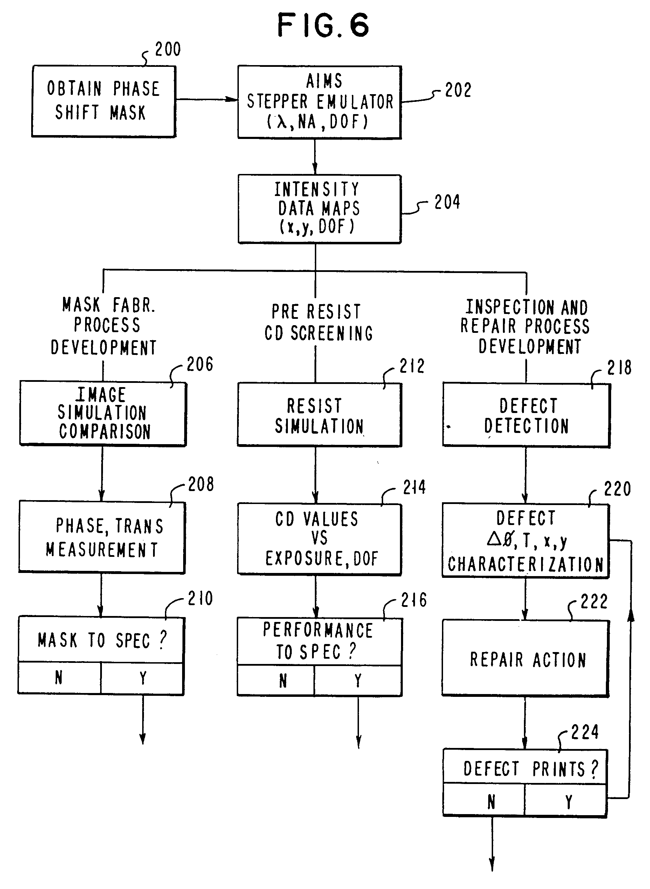

Fig. 6 is a possible process flowchart. A phase shift mask is received at step 200. At step 202 data is acquired using the apparatus and method of the invention. At step 204 intensity data maps are generated as outlined above. The data can be used in mask fabrication process development. At step 206 image simulations are made and a comparison to a simulation model or a known mask is conducted. At step 208 phase transmission measurements are made. At step 210 a determination is made as to whether the mask meets specification.

Alternatively, pre-resist CD screening can be accomplished. At step 212 a resist simulation is produced. At step 214 CD values are obtained as a function of exposures and depth of focus. At step 216 a decision is made whether the mask performs to specification.

The apparatus and method of the invention can also be integrated into the inspection and repair process. Defect detection can be accomplished at step 218. At step 220 the defects are characterized with respect to phase shift and transmission as a function of xy position. At step 222 repairs are made using a possible assortment of repair actions, including further etching of the mask. At step 224 a determination is made as to whether the repair of the characterized defects have been successful. If the defects still print, then they are again characterized at step 220. Further repair action is taken at step 222 and a further determination is made as to whether the defects print. Assuming that they do not, then the mask has been successfully repaired.

While the invention has been particularly shown and described with respect to preferred embodiments thereof, it will be understood by those skilled in the art that changes in form and detailed may be made therein without departing from the scope and spirit of the invention.

## Claims

1. An image measurement system (12) comprising:
a light source (20); means (22) for providing light of a selected frequency; coherence adjusting means (24-39) for adjusting coherence of the light;
positioning means (42) for adjustably positioning an object (44) with respect to said system (12);
imaging means (46, 48) for producing an enlarged optically equivalent stepper image of said object (44); said imaging means (46, 48) including an adjustment means (50) for adjusting numerical aperture; and
image capture means (15) for capturing an image produced by said imaging means (46, 48).

2. The system (12) of claim 1 wherein said coherence adjusting means (24-39) includes angle adjusting means (34) for adjusting an angle of said light with respect to an optical axis (45) of said system (12).

3. The system (12) of claim 1 or 2 wherein said light source (20) comprises a multiwavelength light generator and frequency selection means for selecting a frequency of light produced by said generator for use by said system (12).

4. The system (12) according to any one of the above claims further comprising display means (16) for displaying the image captured by said image capture means (15).

5. The system (12) according to any one of the above claims further comprising analyzing means (14) for analyzing the image captured by said image capture means (15).

6. The system (12) of claim 5 wherein said analyzing means (14) comprises a programmed digital computer (14).

7. The system (12) according to any one of the above claims further comprising control means (39) for controlling size of an illuminated region of the object (44).

8. The system (12) according to any one of the above claims further comprising focus adjustment means (52), said image capture means (15) capturing data at selected focal positions of said focus adjustment means (52).

9. The system (12) according to any one of the above claims wherein said focus adjustment means (52) comprises: an optical plate (66) for changing optical path length, and means (70) for introducing and withdrawing said optical plate (66) from an optical axis (45) of said system.

10. The system (12) according to any one of the above claims wherein said image capture means (15) comprises a plurality of electronic imaging devices (15A, 15B, 15C), each said device being disposed in a different image plane of said system (12).

11. The system (12) of claim 10 wherein a first (15B) of said devices (15A, 15B, 15C) is displaced from a focal plane is a first direction and a second (15C) of said devices (15A, 15B, 15C) is displace from said focal plane in a second direction opposite to said first direction.

12. The system (12) of claim 11 further comprising combining means (62) for combining signals produced by said first device (15B) and said second device (15C).

13. The system (12) of claim 12 wherein said combining means (62) performs real time subtraction of the signal from said first device (15B) and said second device (15C).

14. A method for producing images of an object (44) comprising the steps of providing electromagnetic energy of a selected frequency; adjusting coherence of the energy provided; positioning the object so that said electromagnetic energy illuminates a selected portion of the object; producing an enlarged optically stepper equivalent image of the object; and capturing the image produced.

15. The method of claim 14 further comprising the steps of extracting data from the image, and analyzing the data to determine the optical characteristics of the object.

16. The method of claim 14 further comprising capturing successive images at points above and below focus.

17. The method of claim 14 wherein the step of producing an optically stepper equivalent image includes adjusting a numerical aperture of an imaging system (12) used to produce said image.

18. The system (12) or method according to any one of the above claims wherein the object (44) is a chrome photolithographic mask.

19. The system (12) or method according to any one of the above claims wherein the object (44) is a phase shift mask.
